# EUROPEAN PATENT APPLICATION

(11) **EP 4 822 317 A2**
(43) Date of publication of application: **14.10.2026**
(21) Application number: 26198586.5
(22) Date of filing: 19.07.2018
(51) Int. Cl.: G01L 1/22

(54) **STRAIN TRANSFER STACKING IN A MEMS FORCE SENSOR**

(30) Priority: 19.07.2017 US 201762534287 P
(62) Document number(s) of the earlier application(s) in accordance with Art. 76 EPC: 18834426.1 / 3 655 740
(71) Applicant: Nextinput, Inc., Mountain View, California 94043 (US)
(72) Inventor: TSAI, Julius Minglin, Mountain View, 94043 (US); BENJAMIN, Dan, Mountain View, 94043 (US)
(74) Representative: D Young & Co LLP

(57) **Abstract**

Described herein is a ruggedized microelectromechanical ("MEMS") force sensor including a sensor die and a strain transfer layer. The MEMS force sensor employs piezoresistive or piezoelectric strain gauges for strain sensing where the strain is transferred through the strain transfer layer, which is disposed on the top or bottom side of the sensor die. In the case of the top side strain transfer layer, the MEMS force sensor includes mechanical anchors. In the case of the bottom side strain transfer layer, the protection layer is added on the top side of the sensor die for bond wire protection.

## Description

### CROSS-REFERENCE TO RELATED APPLICATIONS

This application claims the benefit of U.S. provisional patent application No. 62/534,287, filed on July 19, 2017, and entitled "STRAIN TRANSFER STACKING IN A MEMS FORCE SENSOR," the disclosures of which is expressly incorporated herein by reference in its entirety.

### FIELD OF TECHNOLOGY

The present disclosure relates to microelectromechanical ("MEMS") force sensor with a strain transfer layer.

### BACKGROUND

Force sensing applications require a medium to transfer force or strain to the sensing element. In conventional systems, the transfer medium is typically implemented on the assembly mechanism but not on the sensor itself. When the transfer medium is implemented on the assembly mechanism, there is always tolerance in the alignment between the transfer medium and the sensor. For better accuracy and tighter tolerance, there is a need to implement the transfer medium onto the sensor.

### SUMMARY

The present disclosure pertains to a MEMS force sensor comprising a strain transfer layer. According to one implementation described herein, the strain transfer layer is disposed on the top surface of the sensor die, and the sensor die is supported by mechanical anchors at the bottom surface of the sensor die. The sensing element can be either piezoresistive or piezoelectric and can be electrically coupled to the mechanical anchors.

According to another implementation, the strain transfer layer is disposed on the bottom surface of the sensor die, and a protective layer is disposed on the top surface of the sensor die. In this solution, the strain transfer layer also serves as a mechanical support for the MEMS force sensor while the MEMS force sensor is mounted to a force sensitive surface. Additionally, the sensing element can be either piezoresistive or piezoelectric.

Another example MEMS force sensor is described herein. The MEMS force sensor can include a sensor die configured to receive an applied force, where the sensor die defines a top side and a bottom side opposite thereto. The MEMS force sensor can also include at least one strain sensing element arranged on the sensor die, a strain transfer layer arranged on the top side of the sensor die, and at least one mechanical anchor arranged on the bottom side of the sensor die. The at least one strain sensing element can be configured to convert a strain to an analog electrical signal that is proportional to the strain. The strain transfer layer can be configured to transfer the strain to the sensor die.

Alternatively or additionally, the at least one mechanical anchor can be configured to directly attach to an external surface. This allows strain to be transferred properly to the sensor die.

Alternatively or additionally, the at least one strain sensing element can at least partially overlap with the at least one mechanical anchor.

Alternatively or additionally, the at least one mechanical anchor and the at least one strain sensing element can be electrically coupled.

Alternatively or additionally, the strain transfer layer can extend entirely over a top surface of the sensor die and wraps around an edge of the sensor die.

Alternatively or additionally, the strain transfer layer can be coextensive with a top surface of the sensor die.

Alternatively or additionally, the strain transfer layer can extend only partially over a top surface of the sensor die.

Alternatively or additionally, the strain transfer layer can be formed of a material softer than silicon. Alternatively, the strain transfer layer can be formed of a material harder than silicon.

Alternatively or additionally, the at least one strain sensing element can be formed of a piezoresistive material or a piezoelectric material.

Another example MEMS force sensor is described herein. The MEMS force sensor can include a sensor die configured to receive an applied force, where the sensor die defines a top side and a bottom side opposite thereto. The MEMS force sensor can also include at least one strain sensing element arranged on the sensor die, a strain transfer layer arranged on the bottom side of the sensor die, and a protective layer arranged on the top side of the sensor die. The at least one strain sensing element can be configured to convert a strain to an analog electrical signal that is proportional to the strain. The strain transfer layer can be configured to transfer the strain to the sensor die.

Alternatively or additionally, the MEMS force sensor can include an electrical connector arranged on the strain transfer layer. The at least one strain sensing element and the electrical connector can be electrically coupled.

Alternatively or additionally, the MEMS force sensor can include a bonding wire. The protective layer can cover and protect the bonding wire.

Other systems, methods, features and/or advantages will be or may become apparent to one with skill in the art upon examination of the following drawings and detailed description. It is intended that all such additional systems, methods, features and/or advantages be included within this description and be protected by the accompanying claims.

### BRIEF DESCRIPTION OF THE FIGURES

The components in the drawings are not necessarily to scale relative to each other. Like reference numerals designate corresponding parts throughout the several views. These and other features will become more apparent in the detailed description in which reference is made to the appended drawings wherein:

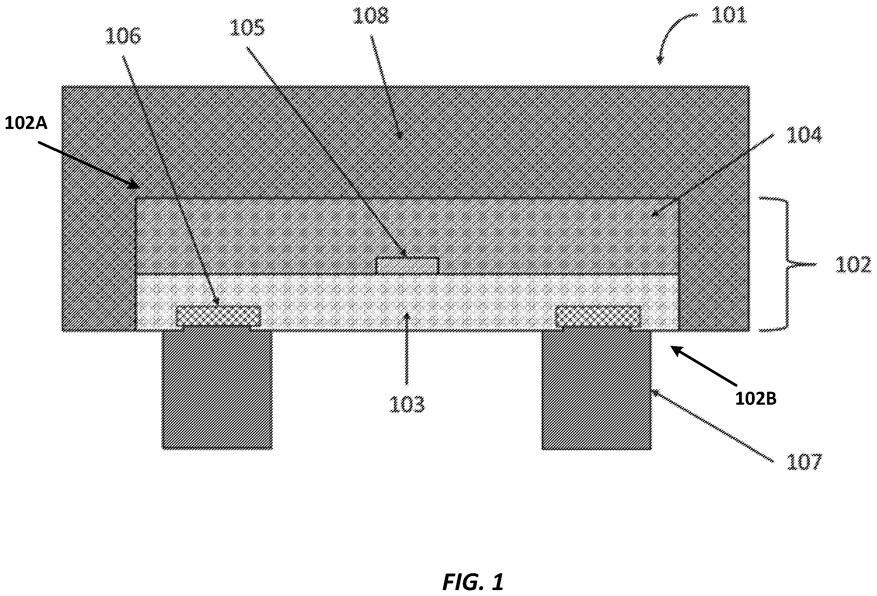

Figure 1 is a cross-sectional view of a MEMS force sensor according to an implementation described herein. The MEMS force sensor includes a piezoresistive sensing element with a mechanical anchor disposed on the bottom side of the sensor die and a strain transfer layer disposed on the top side of the sensor die. The strain transfer layer is larger than the sensor die.

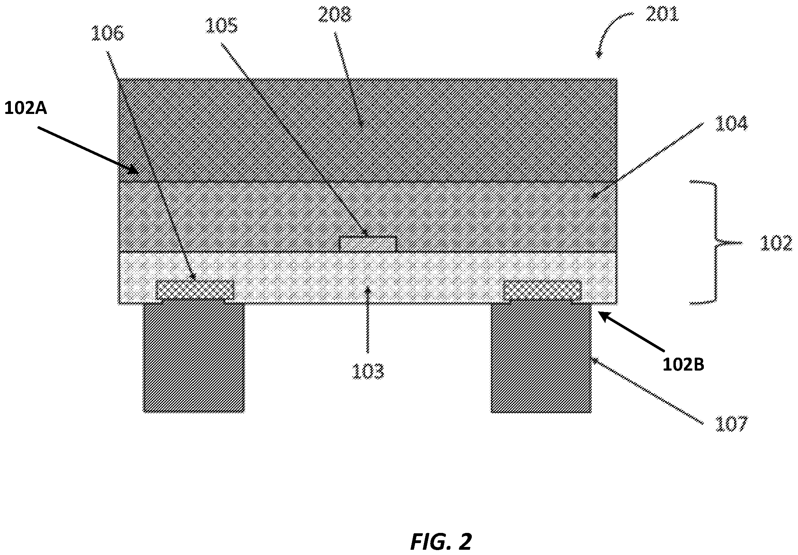

Figure 2 is a cross-sectional view of another MEMS force sensor according to an implementation described herein. The MEMS force sensor includes a piezoresistive sensing element with a mechanical anchor disposed on the bottom side of the sensor die and a strain transfer layer disposed on the top side of the sensor die. The strain transfer layer is the same size as the sensor die.

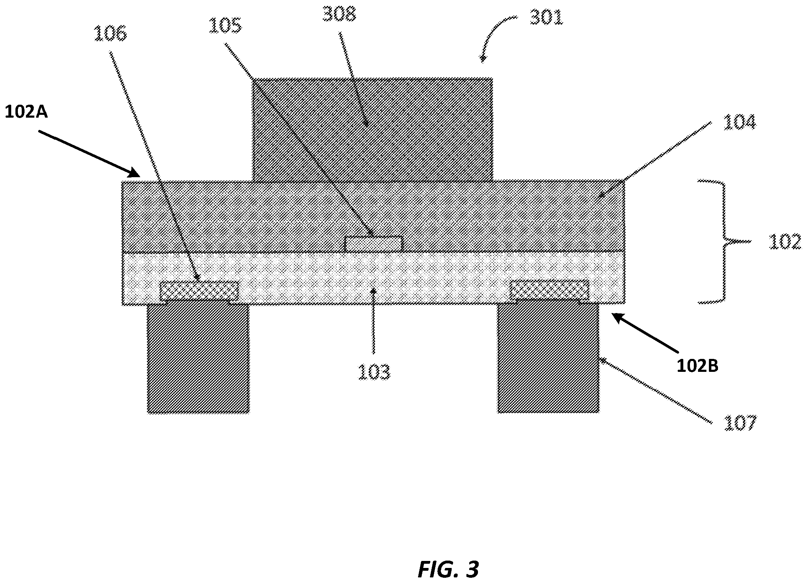

Figure 3 is a cross-sectional view of another MEMS force sensor according to an implementation described herein. The MEMS force sensor includes a piezoresistive sensing element with a mechanical anchor disposed on the bottom side of the sensor die and a strain transfer layer disposed on the top side of the sensor die. The strain transfer layer is smaller than the sensor die.

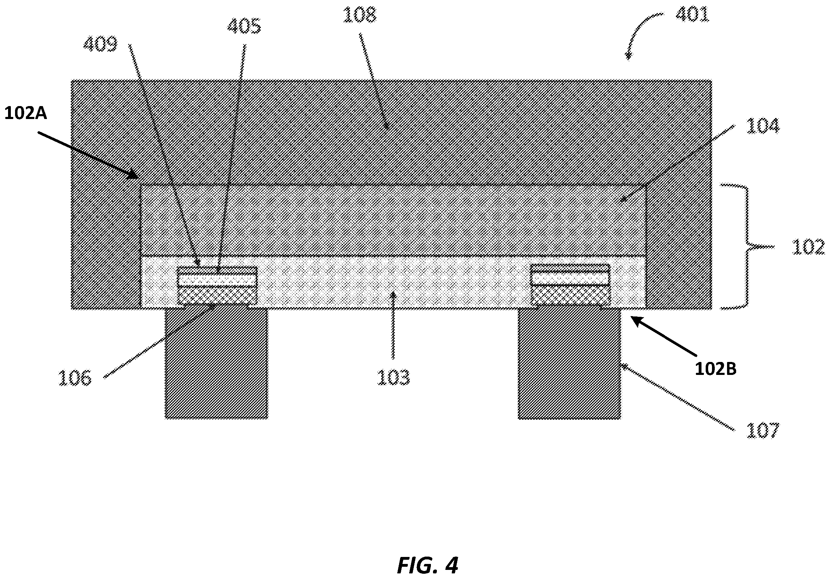

Figure 4 is a cross-sectional view of another MEMS force sensor according to an implementation described herein. The MEMS force sensor includes a piezoelectric sensing element with a mechanical anchor disposed on the bottom side of the sensor die and a strain transfer layer disposed on the top side of the sensor die. The strain transfer layer is larger than the sensor die.

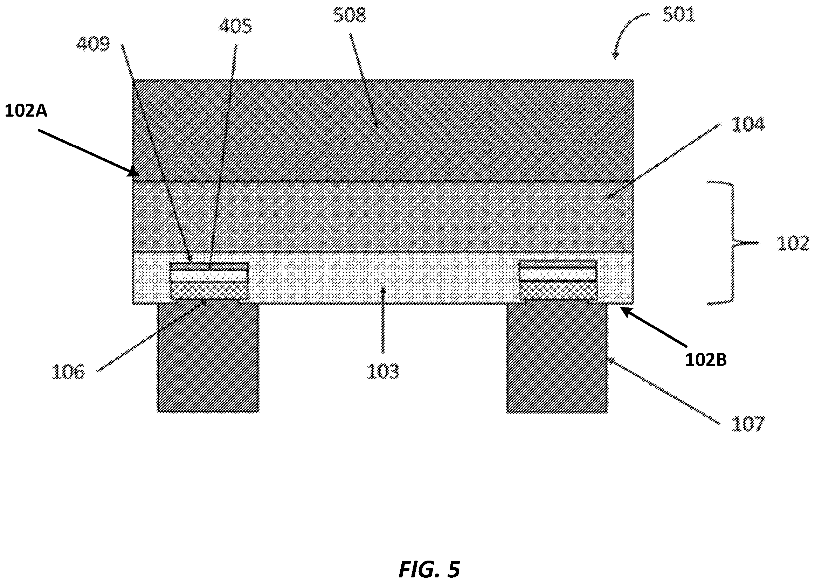

Figure 5 is a cross-sectional view of another MEMS force sensor according to an implementation described herein. The MEMS force sensor includes a piezoelectric sensing element with a mechanical anchor disposed on the bottom side of the sensor die and a strain transfer layer disposed on the top side of the sensor die. The strain transfer layer is the same size as the sensor die.

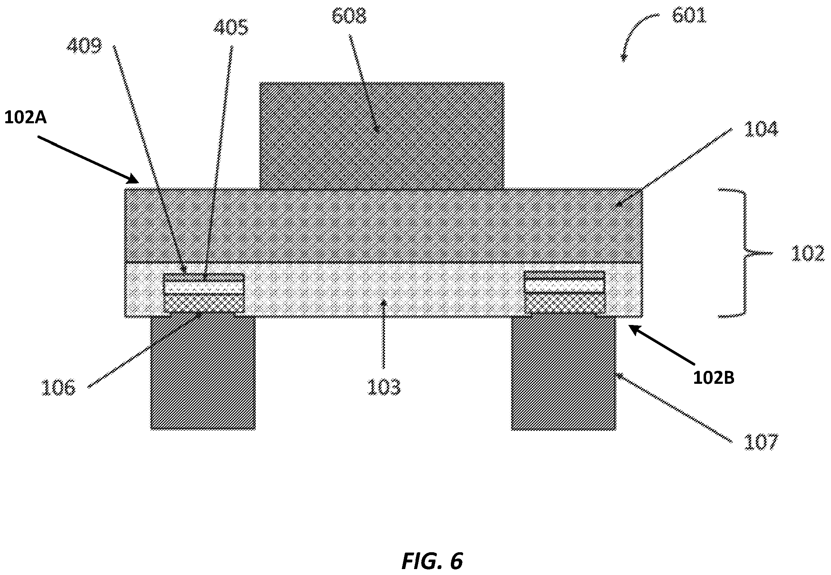

Figure 6 is a cross-sectional view of another MEMS force sensor according to an implementation described herein. The MEMS force sensor includes a piezoelectric sensing element with a mechanical anchor disposed on the bottom side of the sensor die and a strain transfer layer disposed on the top side of the sensor die. The strain transfer layer is smaller than the sensor die.

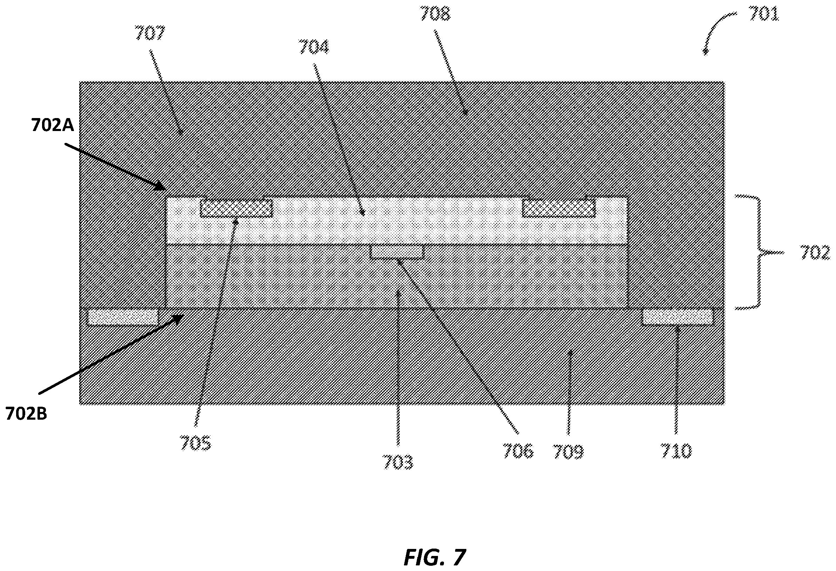

Figure 7 is a cross-sectional view of another MEMS force sensor according to an implementation described herein. The MEMS force sensor includes a piezoresistive sensing element with a strain transfer layer disposed on the bottom side of the sensor die and a protective layer on the top side of the sensor die.

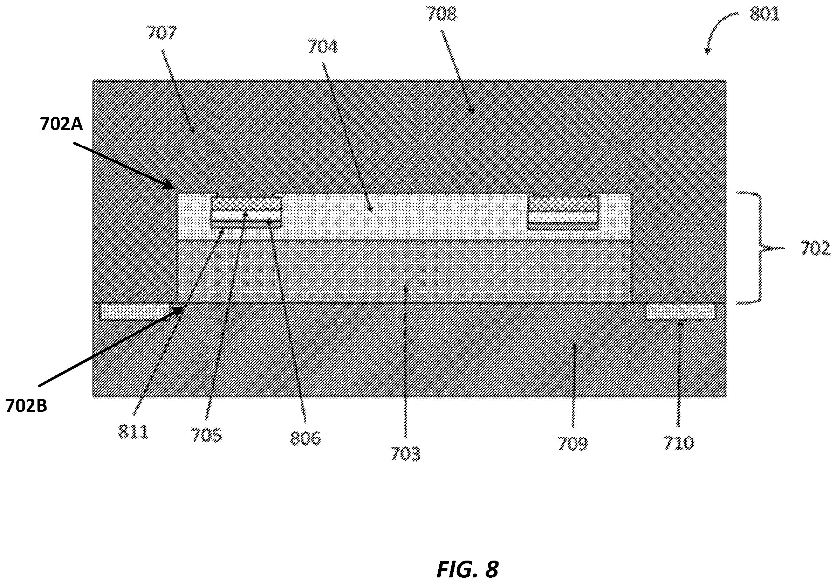

Figure 8 is a cross-sectional view of another MEMS force sensor according to an implementation described herein. The MEMS force sensor includes a piezoelectric sensing element with a strain transfer layer disposed on the bottom side of the sensor die and a protective layer on the top side of the sensor die.

### DETAILED DESCRIPTION

The present disclosure can be understood more readily by reference to the following detailed description, examples, drawings, and their previous and following description. However, before the present devices, systems, and/or methods are disclosed and described, it is to be understood that this disclosure is not limited to the specific devices, systems, and/or methods disclosed unless otherwise specified, and, as such, can, of course, vary. It is also to be understood that the terminology used herein is for the purpose of describing particular aspects only and is not intended to be limiting.

The following description is provided as an enabling teaching. To this end, those skilled in the relevant art will recognize and appreciate that many changes can be made, while still obtaining beneficial results. It will also be apparent that some of the desired benefits can be obtained by selecting some of the features without utilizing other features. Accordingly, those who work in the art will recognize that many modifications and adaptations may be possible and can even be desirable in certain circumstances, and are contemplated by this disclosure. Thus, the following description is provided as illustrative of the principles and not in limitation thereof.

As used throughout, the singular forms "a," "an" and "the" include plural referents unless the context clearly dictates otherwise. Thus, for example, reference to "a sensing element" can include two or more such sensing elements unless the context indicates otherwise.

The term "comprising" and variations thereof as used herein is used synonymously with the term "including" and variations thereof and are open, non-limiting terms.

Ranges can be expressed herein as from "about" one particular value, and/or to "about" another particular value. When such a range is expressed, another aspect includes from the one particular value and/or to the other particular value. Similarly, when values are expressed as approximations, by use of the antecedent "about," it will be understood that the particular value forms another aspect. It will be further understood that the endpoints of each of the ranges are significant both in relation to the other endpoint, and independently of the other endpoint.

As used herein, the terms "optional" or "optionally" mean that the subsequently described event or circumstance may or may not occur, and that the description includes instances where said event or circumstance occurs and instances where it does not.

Referring now to Figure 1, a microelectromechanical system ("MEMS") force sensor 101 for measuring a force applied to at least a portion thereof is described. The MEMS force sensor 101 can include a sensor die 102, which defines opposing sides 102A and 102B. For example, the top side and the bottom side are labeled 102A and 102B, respectively. As described below, a strain transfer layer 108 can be disposed on the top side 102A of the sensor die 102. As shown in Figure 1, the strain transfer layer 108 is arranged on (e.g., layered on top of, deposited on, formed on, in contact with, etc.) a top surface of the sensor die 102. Additionally, a mechanical anchor 107 can be disposed on the bottom side 102B of the sensor die 102. In other words, the mechanical anchor 107 can be arranged on an opposite side of the sensor die 102 in relation to the strain transfer layer 108. The mechanical anchors 108 can be used to mount the MEMS force sensor 101 to an external surface such as a portion of a force-sensitive device and/or another circuit substrate. The external surface can be part of a multilayer stacking structure and can optionally provide electrical coupling of the MEMS force sensor 101 to other electronics components. It should be understood that the number of mechanical anchors 107 (i.e., two) shown in Figure 1 is only provided as an example. This disclosure contemplates that the MEMS force sensor 101 can include more or less mechanical anchors than as shown in Figure 1.

The sensor die 102 can further include a dielectric layer 103, a semiconductor layer 104, a piezoresistive sensing element 105, and a metal layer 106. The metal layer 106 can be electrically conductive material (e.g., aluminum, gold, silver, etc.), the semiconductor layer 104 can be silicon or other semiconductor material (e.g., gallium arsenide (GaAs) or silicon carbide (SiC)), and the dielectric layer 103 can be a dielectric material. As shown in Figure 1, the piezoresistive sensing element 105 is arranged on the semiconductor material 104, and the dielectric layer 103 is provided over the surface of the semiconductor material 104 on which the piezoresistive sensing element 105 is arranged. For example, the piezoresistive sensing element 105 can be disposed on the bottom side 102B of the sensor die 102, i.e., the piezoresistive sensing element 105 can be arranged on an opposite side of the sensor die 102 in relation to the strain transfer layer 108. Additionally, the piezoresistive sensing element 105 can be diffused, deposited, or implanted on a surface of the semiconductor layer 104. It should be understood that a single piezoresistive sensing element is shown in Figure 1 only as an example. This disclosure contemplates that the MEMS force sensor 101 can include a plurality of piezoresistive sensing elements.

The piezoresistive sensing element 105 can change an electrical characteristic (i.e., resistance) in response to deflection of a portion of the sensor die 102. The change in electrical characteristic can be detected as an analog electrical signal (e.g., change in voltage). For example, as strain is induced in the sensor die 102 proportional to the force "F" applied to the MEMS force sensor 101, a localized strain is produced on the piezoresistive sensing element 105 such that the piezoresistive sensing element 105 experiences compression or tension, depending on its specific orientation. As the piezoresistive sensing element 105 compresses and tenses, its resistivity changes in opposite fashion. Accordingly, a Wheatstone bridge circuit including a plurality (e.g., four) piezoresistive sensing elements (e.g., two of each orientation relative to strain) becomes unbalanced and produces a differential voltage across the positive signal terminal and the negative signal terminal. This differential voltage is directly proportional to the applied force "F" on the MEMS force sensor 101. Example MEMS force sensors using piezoresistive sensing elements are described in U.S. Patent No. 9,487,388, issued November 8, 2016 and entitled "Ruggedized MEMS Force Die;" U.S. Patent No. 9,493,342, issued November 15, 2016 and entitled "Wafer Level MEMS Force Dies;" U.S. Patent No. 9,902,611, issued February 27, 2018 and entitled "Miniaturized and ruggedized wafer level mems force sensors;" and U.S. Patent Application Publication No. 2016/0363490 to Campbell et al., filed June 10, 2016 and entitled "Ruggedized wafer level mems force sensor with a tolerance trench," the disclosures of which are incorporated by reference in their entireties.

As described above, the mechanical anchor 107 can be used to attach the MEMS force sensor 101 to an external surface such as another circuit substrate. For example, the mechanical anchor 107 can be configured to directly attach to an external surface. This disclosure contemplates that the external surface is a solid surface that serves as an adequate mechanical ground that does not deform. Attaching the MEMS force sensor 101 to such a solid surface using the mechanical anchor 107 allows the strain to be transferred properly to the sensor die 102. In some implementations, the piezoresistive sensing element 105 can be electrically coupled to the mechanical anchor 107. Optionally, the piezoresistive sensing element 105 and the mechanical anchor 107 can overlap with one another such that they can be electrically coupled using a conductive through-hole. In this implementation, the mechanical anchor 107 can be a conductive material such as metal. For example, the piezoresistive sensing element 105 can be electrically coupled to the metal layer 106, which can be electrically coupled to the mechanical anchor 107. In this way, the differential voltage signal described above can be transferred from the sensor die 102 to a circuit for further processing.

As depicted in Figure 1, the strain transfer layer 108 can be larger than the sensor die 102. For example, in Figure 1, the strain transfer layer 108 extends entirely over the top surface of the sensor die 102 and also wraps around the edges of the sensor die 102. In this configuration, the strain transfer layer 108 can protect the sensor die 102 (e.g., made of brittle semiconductor material such as Si) from breakage caused by impact. The strain transfer layer 108 can also improve the sensitivity of the MEMS force sensor 101. In some implementations, the strain transfer layer 108 is comprised of a material softer than the semiconductor layer 104 material (e.g., silicon), such as molding compound, plastic, or tape, for example. For example, a material hardness (e.g., ability to resist plastic deformation) of the strain transfer layer 108 can be less than a material hardness of the semiconductor layer 104. In other implementations, the strain transfer layer 108 is comprised of a material harder than the semiconductor layer 104 material (e.g., silicon), such as nickel, titanium, or steel, for example. For example, a material hardness (e.g., ability to resist plastic deformation) of the strain transfer layer 108 can be greater than a material hardness of the semiconductor layer 104. Alternatively or additionally, in some implementations, the strain sensing element (e.g., piezoresistive sensing element 105 in Figures 1-3 and 7) is comprised of a piezoresistive material, such as single crystal silicon, poly-silicon, or gallium arsenide, for example. In other implementations, the strain sensing element (e.g., piezoelectric sensing element 405 in Figures 4-6 and 8) is comprised of piezoelectric material, such as aluminum nitride, zinc oxide, or lead zirconate titanate (PZT), for example. It should be understood that the above materials for the strain transfer layer 108 and/or strain sensing element are provided only as examples. This disclosure contemplates that the strain transfer layer and/or strain sensing element can be made of other materials. By including the strain transfer layer as part of the MEMS force sensor 101, the strain is transferred through the strain transfer layer 108 to the MEMS force sensor 101, which can be mounted to a solid surface.

Referring now to Figure 2, a microelectromechanical system ("MEMS") force sensor 201 for measuring a force applied to at least a portion thereof is described. The MEMS force sensor 201 can include a sensor die 102 and a strain transfer layer 208. The sensor die 102 can define opposing sides 102A and 102B. The sensor die 102 can further include a dielectric layer 103, a semiconductor layer 104, a piezoresistive sensing element 105, and a metal layer 106. Additionally, the MEMS force sensor 201 can include a mechanical anchor 107. These features of the MEMS force sensor 201 are similar to those described above with regard to Figure 1 and are therefore not described in further detail below. As depicted in Figure 2, the strain transfer layer 208 can be equal in size to the sensor die 102. For example, the strain transfer layer 208 is coextensive with the top surface of the sensor die 102. In other words, the strain transfer layer 208 completely covers the top surface of the sensor die 102. Unlike the strain transfer layer shown in Figure 1, however, the strain transfer layer 208 does not wrap around the edges of the sensor die 102. In this configuration, the strain transfer layer 208 can protect the top side 102A of the sensor die 102 from breakage caused by impact. The strain transfer layer 108 can also improve the sensitivity of the MEMS force sensor 201. By including the strain transfer layer as part of the MEMS force sensor 201, the strain is transferred through the strain transfer layer 208 to the MEMS force sensor 201, which can be mounted to a solid surface.

Referring now to Figure 3, a microelectromechanical system ("MEMS") force sensor 301 for measuring a force applied to at least a portion thereof is described. The MEMS force sensor 301 can include a sensor die 102 and a strain transfer layer 308. The sensor die 102 can define opposing sides 102A and 102B. The sensor die 102 can further include a dielectric layer 103, a semiconductor layer 104, a piezoresistive sensing element 105, and a metal layer 106. Additionally, the MEMS force sensor 301 can include a mechanical anchor 107. These features of the MEMS force sensor 301 are similar to those described above with regard to Figure 1 and are therefore not described in further detail below. As depicted in Figure 3, the strain transfer layer 308 can be smaller than the sensor die 102. For example, the strain transfer layer 308 extends only partially over the top surface of the sensor die 102. Unlike the strain transfer layer shown in Figure 2, the strain transfer layer 308 does not completely cover the top surface of the sensor die 102. In this configuration, the strain transfer layer 308 can provide a concentric load to the sensor die 102. The strain transfer layer 308 can also improve the sensitivity of the MEMS force sensor 301. By including the strain transfer layer as part of the MEMS force sensor 301, the strain is transferred through the strain transfer layer 308 to the MEMS force sensor 301, which can be mounted to a solid surface.

Referring now to Figure 4, a microelectromechanical system ("MEMS") force sensor 401 for measuring a force applied to at least a portion thereof is described. Except for the sensing element, the MEMS force sensor 401 has the same features as the MEMS force sensor described with regard to Figure 1. In particular, the MEMS force sensor 401 can include a sensor die 102 and a strain transfer layer 108. The sensor die 102 can define opposing sides 102A and 102B. The sensor die 102 can further include a dielectric layer 103, a semiconductor layer 104, a top electrode 409, a piezoelectric sensing element 405, and a metal layer 106. The metal layer 106 serves as the bottom electrode. Additionally, the MEMS force sensor 401 can include a mechanical anchor 107. As depicted in Figure 4, the strain transfer layer 108 can be larger than the sensor die 102. For example, in Figure 4, the strain transfer layer 108 extends entirely over the top surface of the sensor die 102 and also wraps around the edges of the sensor die 102. By including the strain transfer layer as part of the MEMS force sensor 401, the strain is transferred through the strain transfer layer 108 to the MEMS force sensor 401, which can be mounted to a solid surface.

As shown in Figure 4, the dielectric layer 103 is provided over the surface of the semiconductor material 104, and the piezoelectric sensing element 405 is arranged on the dielectric layer 103. For example, the piezoelectric sensing element 405 can be disposed on the bottom side 102B of the sensor die 102, i.e., the piezoelectric sensing element 405 can be arranged on an opposite side of the sensor die 102 in relation to the strain transfer layer 108. It should be understood that a single piezoelectric sensing element is shown in Figure 4 only as an example. This disclosure contemplates that the MEMS force sensor 401 can include a plurality of piezoelectric sensing elements. Additionally, this disclosure contemplates that the piezoelectric sensing element 405 can be deposited on a surface of the dielectric layer 103. The piezoelectric sensing element 405, which is arranged between opposing electrodes as described above, can change an electrical characteristic (i.e., charge) in response to deflection of a portion of the sensor die 102. For example, as strain is induced in the sensor die 102 proportional to the force "F" applied to the MEMS force sensor 401, the piezoelectric sensing element 405 changes charge. Thus, the change in electrical characteristic can be detected as an analog electrical signal (e.g., change in voltage) at the top and bottom electrodes 409 and 106. This disclosure contemplates that the change in voltage can be correlated with the amount of "F" applied to the MEMS force sensor 401.

Referring now to Figure 5, a microelectromechanical system ("MEMS") force sensor 501 for measuring a force applied to at least a portion thereof is described. The MEMS force sensor 501 can include a sensor die 102 and a strain transfer layer 508. The sensor die 102 can define opposing sides 102A and 102B. The sensor die 102 can further include a dielectric layer 103, a semiconductor layer 104, a top electrode 409, a piezoelectric sensing element 405, and a metal layer 106. The metal layer 106 serves as the bottom electrode for the piezoelectric sensing element 405. Additionally, the MEMS force sensor 501 can include a mechanical anchor 107. These features of the MEMS force sensor 501 are similar to those described above with regard to Figure 4 and are therefore not described in further detail below. As depicted in Figure 5, the strain transfer layer 508 can be equal in size to the sensor die 102. For example, the strain transfer layer 508 is coextensive with the top surface of the sensor die 102. In other words, the strain transfer layer 508 completely covers the top surface of the sensor die 102. Unlike the strain transfer layer shown in Figure 4, however, the strain transfer layer 508 does not wrap around the edges of the sensor die 102. By including the strain transfer layer as part of the MEMS force sensor 501, the strain is transferred through the strain transfer layer 508 to the MEMS force sensor 501, which can be mounted to a solid surface.

Referring now to Figure 6, a microelectromechanical system ("MEMS") force sensor 601 for measuring a force applied to at least a portion thereof is described. The MEMS force sensor 601 can include a sensor die 102 and a strain transfer layer 608. The sensor die 102 can define opposing sides 102A and 102B. The sensor die 102 can further include a dielectric layer 103, a semiconductor layer 104, a top electrode 409, a piezoelectric sensing element 405, and a metal layer 106. The metal layer 106 serves as the bottom electrode for the piezoelectric sensing element 405. Additionally, the MEMS force sensor 601 can include a mechanical anchor 107. These features of the MEMS force sensor 601 are similar to those described above with regard to Figure 4 and are therefore not described in further detail below. As depicted in Figure 6, the strain transfer layer 608 can be smaller than the sensor die 102. For example, the strain transfer layer 608 extends only partially over the top surface of the sensor die 102. Unlike the strain transfer layer shown in Figure 5, the strain transfer layer 608 does not completely cover the top surface of the sensor die 102. By including the strain transfer layer as part of the MEMS force sensor 601, the strain is transferred through the strain transfer layer 608 to the MEMS force sensor 601, which can be mounted to a solid surface.

Referring now to Figure 7, a microelectromechanical system ("MEMS") force sensor 701 for measuring a force applied to at least a portion thereof is described. The MEMS force sensor 701 can include a sensor die 702, which defines opposing sides 702A and 702B. For example, the top side and the bottom side are labeled 702A and 702B, respectively. As described below, a strain transfer layer 709 can be disposed on the bottom side 702B of the sensor die 102. As shown in Figure 7, the strain transfer layer 709 is arranged on (e.g., layered on top of, deposited on, formed on, in contact with, etc.) a bottom surface of the sensor die 702. Additionally, a protective layer 708 can be disposed on the top side 702A of the sensor die 702. As shown in Figure 7, the protective layer 708 is arranged on (e.g., layered on top of, deposited on, formed on, in contact with, etc.) a top surface of the sensor die 702. In other words, the protective layer 708 can be arranged on an opposite side of the sensor die 702 in relation to the strain transfer layer 709.

The sensor die 702 can further include a semiconductor layer 703, a dielectric layer 704, a metal layer 705, and a piezoresistive sensing element 706. The metal layer 705 can be electrically conductive material (e.g., aluminum, gold, silver, etc.), the semiconductor layer 703 can be silicon or other semiconductor material, and the dielectric layer 704 can be a dielectric material. As shown in Figure 7, the piezoresistive sensing element 706 is arranged on the semiconductor material 703, and the dielectric layer 704 is provided over the surface of the semiconductor material 703 on which the piezoresistive sensing element 706 is arranged. The piezoresistive sensing element 706 can be disposed on the top side 702A of the sensor die 702, i.e., the piezoresistive sensing element 706 can be arranged on an opposite side of the sensor die 702 in relation to the strain transfer layer 709. It should be understood that a single piezoresistive sensing element is shown in Figure 7 only as an example. This disclosure contemplates that the MEMS force sensor 701 can include a plurality of piezoresistive sensing elements. Additionally, this disclosure contemplates that the piezoresistive sensing element 706 can be diffused, deposited, or implanted on a surface of the semiconductor layer 703. The functionality of a piezoresistive sensing element is described above.

As shown in Figure 7, the protective layer 708 covers a bonding wire 707 and protects the top surface of the sensor die 702. The protective layer 708 can be formed of a resin, epoxy, plastic, or other material that can be molded. The bonding wire 707 can be a conductive material such as metal. In some implementations, the piezoresistive sensing element 706 can be electrically coupled to the metal layer 705, which can be electrically coupled to an electrical connector 710 via the bonding wire 707. As shown in Figure 7, the electrical connector 710 can be arranged on the strain transfer layer 709. In some implementations, the electrical connector 710 can be a metal frame provided on the strain transfer layer 709. Accordingly, the differential voltage signal described above can be transferred from the sensor die 702 to a circuit for further processing. It should be understood that the number of bonding wires 707 (i.e., two) and/or the number of electrical connectors 710 (i.e., two) shown in Figure 7 are only provided as an example. This disclosure contemplates that the MEMS force sensor 701 can include more or less bonding wires and/or more or less electrical connectors than as shown in Figure 7. Additionally, the MEMS force sensor 701 can be mounted to a force sensing surface (e.g., a surface external to the MEMS force sensor 701) through the strain transfer layer 709. Materials for the strain transfer layer are described above. By including the strain transfer layer as part of the MEMS force sensor 701, the strain is transferred through the strain transfer layer 709 to the MEMS force sensor 701 while the MEMS force sensor 701 is mounted to the force sensing surface.

Referring now to Figure 8, a microelectromechanical system ("MEMS") force sensor 801 for measuring a force applied to at least a portion thereof is described. Except for the sensing element, the MEMS force sensor 801 has the same features as the MEMS force sensor described with regard to Figure 7. In particular, the MEMS force sensor 801 can include a sensor die 702 and a strain transfer layer 709. The sensor die 702 can define opposing sides 702A and 702B. The sensor die 102 can further include a semiconductor layer 703, a dielectric layer 704, a metal layer 705, a piezoelectric sensing element 806, and a bottom electrode 811. The metal layer 705 serves as the top electrode. The functionality of a piezoelectric sensing element is described above. Additionally, the MEMS force sensor 801 can include a bonding wire 707 for electrically coupling the metal layer 705 and an electrical connector 710, which allows for transfer of a differential voltage signal from the sensor die 702 to a circuit for further processing. Further, the MEMS force sensor 801 can include a protective layer 708 that covers the bonding wire 707 and protects the top surface of the sensor die 702. By including the strain transfer layer as part of the MEMS force sensor 801, the strain is transferred through the strain transfer layer 709 to the MEMS force sensor 801 while the MEMS force sensor 801 is mounted to a force sensing surface through the strain transfer layer 709.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.
1. A microelectromechanical ("MEMS") force sensor, comprising:
   a sensor die configured to receive an applied force, wherein the sensor die comprises a top side and a bottom side opposite thereto,
   at least one strain sensing element arranged on the sensor die, wherein the at least one strain sensing element is configured to convert a strain to an analog electrical signal that is proportional to the strain,
   a strain transfer layer arranged on the top side of the sensor die, wherein the strain transfer layer is configured to transfer the strain to the sensor die, and
   at least one mechanical anchor arranged on the bottom side of the sensor die.
2. The MEMS force sensor of clause 1, wherein the at least one mechanical anchor is configured to directly attach to an external surface .
3. The MEMS force sensor of any one of clause 1 or 2, wherein the at least one strain sensing element at least partially overlaps with the at least one mechanical anchor.
4. The MEMS force sensor of any one of clauses 1-3, wherein the at least one mechanical anchor and the at least one strain sensing element are electrically coupled.
5. The MEMS force sensor of any one of clauses 1-4, wherein the strain transfer layer extends entirely over a top surface of the sensor die and wraps around an edge of the sensor die.
6. The MEMS force sensor of any one of clauses 1-4, wherein the strain transfer layer is coextensive with a top surface of the sensor die.
7. The MEMS force sensor of any one of clauses 1-4, wherein the strain transfer layer extends only partially over a top surface of the sensor die.
8. The MEMS force sensor of any one of clauses 1-7, wherein the strain transfer layer is formed of a material softer than silicon.
9. The MEMS force sensor of any one of clauses 1-7, wherein the strain transfer layer is formed of a material harder than silicon.
10. The MEMS force sensor of any one of clauses 1-9, wherein the at least one strain sensing element is formed of a piezoresistive material.
11. The MEMS force sensor of any one of clauses 1-9, wherein the at least one strain sensing element is formed of a piezoelectric material.
12. A microelectromechanical ("MEMS") force sensor, comprising:
   a sensor die configured to receive an applied force, wherein the sensor die comprises a top side and a bottom side opposite thereto,
   at least one strain sensing element arranged on the sensor die, wherein the at least one strain sensing element is configured to convert a strain to an analog electrical signal that is proportional to the strain,
   a strain transfer layer that is disposed on the bottom side of the sensor die, wherein the strain transfer layer is configured to transfer the strain to the sensor die, and
   a protective layer that is disposed on the top side of the sensor die.
13. The MEMS force sensor of clause 12, further comprising an electrical connector arranged on the strain transfer layer, wherein the at least one strain sensing element and the electrical connector are electrically coupled.
14. The MEMS force sensor of any one of clause 12 or 13, wherein the at least one strain sensing element is formed of piezoresistive material.
15. The MEMS force sensor of any one of clause 12 or 13, wherein the at least one strain sensing element is formed of piezoelectric material.
16. The MEMS force sensor of any one of clauses 12-15, further comprising a bonding wire, wherein the protective layer covers and protects the bonding wire.
17. The MEMS force sensor of any one of clauses 12-16, wherein the strain transfer layer is formed of a material softer than silicon.
18. The MEMS force sensor of any one of clauses 12-16, wherein the strain transfer layer is formed of a material harder than silicon.

## Claims

1. A microelectromechanical ("MEMS") force sensor, comprising:
a sensor die configured to receive an applied force, wherein the sensor die comprises a top side and a bottom side opposite thereto,
at least one strain sensing element arranged on the sensor die, wherein the at least one strain sensing element is configured to convert a strain to an analog electrical signal that is proportional to the strain,
a strain transfer layer that is disposed on the bottom side of the sensor die, wherein the strain transfer layer is configured to transfer the strain to the sensor die, and
a protective layer that is disposed on the top side of the sensor die, wherein the protective layer extends entirely over the top side of the sensor die and wraps around an edge of the sensor die.

2. The MEMS force sensor of claim 1, further comprising an electrical connector arranged on the strain transfer layer, wherein the at least one strain sensing element and the electrical connector are electrically coupled.

3. The MEMS force sensor of claim 1 or claim 2, wherein the at least one strain sensing element is formed of piezoresistive material.

4. The MEMS force sensor of claim 1 or claim 2, wherein the at least one strain sensing element is formed of piezoelectric material.

5. The MEMS force sensor of any preceding claim, further comprising a bonding wire, wherein the protective layer covers and protects the bonding wire.

6. The MEMS force sensor of any preceding claim, wherein the strain transfer layer is formed of a material softer than silicon.

7. The MEMS force sensor of any of claims 1 to 5, wherein the strain transfer layer is formed of a material harder than silicon.
